# FASCICULE DE BREVET EUROPEEN

(11) **EP 1 993 829 B1**
(45) Date de publication et mention de la délivrance du brevet: **16.05.2018**
(21) Numéro de dépôt: 07731698.2
(22) Date de dépôt: 06.03.2007
(51) Int. Cl.: C03C 17/36, B32B 17/10

(54) **SUBSTRAT MUNI D'UN EMPILEMENT DE COUCHES MINCES, EMPILEMENT A PROPRIETES THERMIQUES**
SUBSTRAT ENTHALTEND EINEN STAPEL VON DüNNEN SCHICHTEN, WOBEI DER STAPEL THERMISCHE EIGENSCHAFTEN AUFWEIST
SUBSTRATE COMPRISING A STACK OF THIN LAYERS, THE STACK HAVING THERMAL PROPERTIES

(30) Priorité: 06.03.2006 FR 0650770
(43) Date de publication de la demande: 26.11.2008
(73) Titulaire: SAINT-GOBAIN GLASS FRANCE, 92400 Courbevoie (FR)
(72) Inventeur: REUTLER, Pascal, F-75019 Paris (FR); NADAUD, Nicolas, F-94250 Gentilly (FR); MARTIN, Estelle, F-75005 Paris (FR); LABROUSSE, Laurent, F-75015 Paris (FR)
(74) Mandataire: Saint-Gobain Recherche
(86) Numéro de dépôt international: PCT/FR2007/050881
(87) Numéro de publication internationale: WO 2007/101963

(56) Documents cités:
- EP-A- 0 995 725
- WO-A-2005/051858
- US-A- 4 985 312
- US-A- 5 993 950
- US-A1- 2003 099 842

## Description

L'invention concerne les substrats transparents, notamment en matériau rigide minéral comme le verre, lesdits substrats étant revêtus d'un empilement de couches minces comprenant au moins deux couches fonctionnelles de type métallique pouvant agir sur le rayonnement solaire et/ou le rayonnement infrarouge de grande longueur d'onde.

L'invention concerne plus particulièrement l'utilisation de tels substrats pour fabriquer des vitrages d'isolation thermique et/ou de protection solaire. Ces vitrages peuvent être destinés aussi bien à équiper les bâtiments que les véhicules, en vue notamment de diminuer l'effort de climatisation et/ou d'empêcher une surchauffe excessive (vitrages dits « de contrôle solaire ») et/ou diminuer la quantité d'énergie dissipée vers l'extérieur (vitrages dits « bas émissifs ») entraînés par l'importance toujours croissante des surfaces vitrées dans les bâtiments et les habitacles de véhicules.

Ces vitrages peuvent par ailleurs être intégrés dans des vitrages présentant des fonctionnalités particulières, comme par exemple des vitrages chauffants ou des vitrages électrochromes.

Un type d'empilement de couches connu pour conférer aux substrats de telles propriétés est constitué d'au moins deux couches métalliques fonctionnelles à propriétés de réflexion dans l'infrarouge et/ou dans le rayonnement solaire, notamment de couches fonctionnelles métalliques à base d'argent ou d'alliage métallique contenant de l'argent.

Chaque couche fonctionnelle métallique est déposée sous une forme cristallisée sur une couche de mouillage également cristallisée favorisant l'orientation cristalline adéquate de la couche métallique déposée dessus.

Chaque couche fonctionnelle se trouve disposée entre deux revêtements en matériau diélectrique du type oxyde ou nitrure métallique. Cet empilement est généralement obtenu par une succession de dépôts effectués par une technique utilisant le vide comme la pulvérisation cathodique éventuellement assistée par champ magnétique. Peuvent aussi être prévus un, voire deux, revêtement(s) très fin(s) appelé(s) « revêtement de blocage », disposé(s) directement sous, sur ou de chaque côté de chaque couche métallique fonctionnelle à base d'argent, le revêtement sous-jacent en tant que revêtement d'accrochage, de nucléation et/ou de protection lors d'un éventuel traitement thermique postérieurement au dépôt, et le revêtement sus-jacent en tant que revêtement de protection ou « sacrificiel » afin d'éviter l'altération de l'argent si une couche qui le surmonte est déposée par pulvérisation cathodique en présence d'oxygène ou d'azote et/ou si l'empilement subit postérieurement au dépôt un traitement thermique.

Il est ainsi connu de la demande de brevet européen EP-0 638 528 des empilements de ce type, à deux couches à base d'argent.

Il est connu par ailleurs de la demande de brevet européen N°EP 803 481, l'utilisation sous une couche de mouillage à base d'oxyde de zinc d'une couche amorphe à base d'oxyde mixte de zinc et d'étain directement au contact du substrat.

Il s'avère qu'une telle couche amorphe lorsqu'elle n'est pas déposée directement sur le substrat mais qu'elle est intercalée entre une couche diélectrique sous-jacente et une couche de mouillage permet de modifier l'interface entre la couche diélectrique et la couche de mouillage située au-dessus et ainsi d'améliorer sensiblement la cristallisation de la couche de mouillage ainsi que la cristallisation de la couche métallique fonctionnelle.

Toutefois, l'intégration d'une telle couche amorphe dans chaque revêtement sous-jacent à une couche fonctionnelle et pourvu d'au moins une couche diélectrique sous cette couche amorphe dans un empilement à plusieurs couches fonctionnelles ne permet pas de parvenir dans tous les cas à l'amélioration souhaitée de la cristallisation des couches fonctionnelles et ainsi à l'amélioration souhaitée de la résistivité de l'empilement Les documents WO2005051858, US5993950, US2003099842 et EP0995725 décrivent également des substrats verriers munis d'empilements de couches minces. Le but de l'invention est de parvenir à remédier aux inconvénients de l'art antérieur, en mettant au point un nouveau type d'empilement à couches fonctionnelles du type de ceux décrits précédemment, empilement qui présente une résistivité améliorée, plus faible que dans un empilement similaire à épaisseur de couches fonctionnelles et revêtements équivalents, que l'empilement subisse ou non, un (ou des) traitement(s) thermique(s) à haute température du type bombage, trempe ou recuit et dans le cas où il subit un (ou plusieurs) tel(s) traitement(s), tout en préservant sa qualité optique et sa tenue mécanique.

L'invention a ainsi pour objet, dans son acception la plus large, un substrat, notamment un substrat verrier transparent, selon la revendication 1.

L'invention consiste ainsi à prévoir une couche de lissage non cristallisée sous la couche de mouillage qui elle est cristallisée pour permettre une croissance adéquate de la couche fonctionnelle située au-dessus de cette couche de mouillage, directement au contact de la couche de mouillage ou par l'intermédiaire d'un revêtement de sous-blocage.

L'aspect cristallographique de la couche de lissage est forcément différent de celui de la couche de mouillage puisque la couche de lissage est non cristallisée alors que la couche de mouillage est, pour l'essentiel, cristallisée ; elles ne peuvent donc être confondues de ce point de vue.

Toutefois, il est apparu que dans les empilements à plusieurs couches fonctionnelles, il était important de prendre en considération l'épaisseur des revêtements sous-jacents pour calculer l'épaisseur des couches de lissage présentent dans ces revêtements sous-jacents.

L'invention consiste ainsi à prévoir que l'épaisseur de la couche de lissage d'un revêtement sous-jacent moins épais ne peut pas être supérieure à l'épaisseur de la couche de lissage d'un revêtement sous-jacent plus épais.

L'invention s'applique aux revêtements qui sont sous-jacents à une couche fonctionnelle, quel que soit l'emplacement des couches fonctionnelles dans l'empilement ; toutefois il est préférable que dans un même empilement de couches minces, tous les revêtements sous-jacent comportant une couche de lissage répondent à la définition de l'invention.

Au sens de la présente invention lorsqu'il est précisé qu'un dépôt de couche ou de revêtement (comportant une ou plusieurs couches) est effectué directement sous ou directement sur un autre dépôt, c'est qu'il ne peut y avoir interposition d'aucune couche entre ces deux dépôts.

Les couches de lissage sont à base d'oxyde ; elles ne sont donc pas métalliques.

Les couches de lissage sont dites « non cristallisées » dans le sens où elles sont complètement amorphes sur toute leur épaisseur.

L'intérêt d'une telle couche de lissage est de permettre d'obtenir une interface avec la couche de mouillage directement sus-jacente qui est peu rugueuse. Cette faible rugosité est d'ailleurs observable au microscope électronique à transmission.

Par ailleurs, la couche de mouillage se texture mieux et présente en outre une orientation cristallographique préférentielle plus marquée.

Chaque couche de lissage est ainsi en un matériau différent, tant du point de vue cristallographique que stoechiométrique, de celui de la couche de mouillage sous laquelle elle est directement disposée.

L'invention ne s'applique pas seulement à des empilements ne comportant que deux couches « fonctionnelles », disposées entre trois revêtements dont deux sont des revêtements sous-jacents. Elle s'applique aussi à des empilements comportant trois couches fonctionnelles alternées avec quatre revêtements dont trois sont des revêtements sous-jacents, ou de quatre couches fonctionnelles alternées avec cinq revêtements dont quatre sont des revêtements sous-jacents.

Pour ces empilements pluri couches fonctionnelles, de préférence au moins une, et de préférence encore chaque, couche fonctionnelle est disposée directement sur au moins un revêtement de blocage sous-jacent et/ou directement sous au moins un revêtement de blocage sus-jacent.

Dans le cas des empilements bicouches fonctionnelles, voire également dans les autres cas, le revêtement le moins épais desdits deux revêtements sous-jacents comportant une couche de lissage est, de préférence, le plus proche du substrat, voire au contact du substrat, directement ou indirectement par l'intermédiaire d'une couche de contact par exemple à base d'oxyde de titane (TiO₂).

Dans le cas des empilements à plus de deux couches fonctionnelles, le revêtement sous-jacent le plus éloigné du substrat est le moins épais de deux revêtements sous-jacents adjacents.

Toutes les couches de lissage sont une couche d'oxyde mixte à base de zinc et d'étain.

L'indice de la couche de lissage est, de préférence, inférieur à 2,2.

De préférence en outre, au moins une couche de lissage, voire toutes les couches de lissage, est (ou sont) une couche d'oxyde non stoechiométrique en oxygène et plus particulièrement encore une couche d'oxyde mixte à base de zinc et d'étain sous-stoechiométrique, dopée à l'antimoine (SnZnOₓ:Sb, x étant un nombre).

Par ailleurs, la (ou chaque) couche de lissage présente de préférence une épaisseur géométrique entre 0,1 et 30 nm et de préférence encore comprise entre 0,2 et 10 nm, en particulier pour la moins épaisse des deux concernées.

Dans une variante préférée, au moins un revêtement de blocage est à base de Ni ou de Ti ou est à base d'un alliage à base de Ni, notamment est à base d'un alliage de NiCr.

De plus chaque, couche de mouillage sous-jacente à une couche fonctionnelle est à base d'oxyde de zinc ; ces couches de mouillage peuvent être en particulier à base d'oxyde de zinc dopé à l'aluminium.

L'épaisseur géométrique de chaque couche de mouillage est de préférence comprise entre 2 et 30 nm et de préférence encore comprise entre 3 et 20 nm.

En outre, au moins une, et de préférence chaque, couche diélectrique adjacente à une couche de lissage à l'intérieur desdits revêtements sous-jacents et en particulier la couche diélectrique directement sous-jacente à la couche de lissage, est, de préférence, à base de nitrure, notamment de nitrure de silicium et/ou de nitrure d'aluminium.

L'indice de cette couche diélectrique à base de nitrure est, de préférence, inférieur à 2,2.

Le vitrage selon l'invention incorpore au moins le substrat porteur de l'empilement selon l'invention, éventuellement associé à au moins un autre substrat. Chaque substrat peut être clair ou coloré. Un des substrats au moins notamment peut être en verre coloré dans la masse. Le choix du type de coloration va dépendre du niveau de transmission lumineuse et/ou de l'aspect colorimétrique recherchés pour le vitrage une fois sa fabrication achevée.

Ainsi pour des vitrages destinés à équiper des véhicules, certaines normes imposent que le pare-brise présente une transmission lumineuse T_{L} d'environ 75% et d'autres normes imposent une transmission lumineuse T_{L} d'environ 65% ; un tel niveau de transmission n'étant pas exigé pour les vitrages latéraux ou le toit-auto, par exemple. Les verres teintés que l'on peut retenir sont par exemple ceux qui, pour une épaisseur de 4 mm, présentent une T_{L} de 65 % à 95 %, une transmission énergétique T_{E} de 40 % à 80 %, une longueur d'onde dominante en transmission de 470 nm à 525 nm associée à une pureté de transmission de 0,4 % à 6 % selon l'Illuminant D₆₅, ce que l'on peut « traduire » dans le système de colorimétrie (L, a*, b*) par des valeurs de a* et b* en transmission respectivement comprises entre -9 et 0 et entre -8 et +2.

Pour des vitrages destinés à équiper des bâtiments, le vitrage présente, de préférence, une transmission lumineuse T_{L} d'au moins 75% voire plus pour des applications « bas-émissif », et une transmission lumineuse T_{L} d'au moins 40% voire plus pour des applications « contrôle solaire ».

Le vitrage selon l'invention peut présenter une structure feuilletée, associant notamment au moins deux substrats rigides du type verre par au moins une feuille de polymère thermoplastique, afin de présenter une structure de type verre/empilement de couches minces/feuille(s)/verre. Le polymère peut notamment être à base de polyvinylbutyral PVB, éthylène vinylacétate EVA, polyéthylène téréphtalate PET, polychlorure de vinyle PVC.

Le vitrage peut aussi présenter une structure de vitrage feuilleté dit asymétrique, associant un substrat rigide de type verre à au moins une feuille de polymère de type polyuréthane à propriétés d'absorbeur d'énergie, éventuellement associée à une autre couche de polymères à propriétés « auto-cicatrisantes ». Pour plus de détails sur ce type de vitrage, il est possible de se reporter notamment aux brevets EP-0 132 198, EP-0 131 523, EP-0 389 354.

Le vitrage peut alors présenter une structure de type verre/empilement de couches minces/feuille(s) de polymère.

Les vitrages selon l'invention sont aptes à subir un traitement thermique sans dommage pour l'empilement de couches minces. Ils sont donc éventuellement bombés et/ou trempés.

Le vitrage peut être bombé et/ou trempé en étant constitué d'un seul substrat, celui muni de l'empilement. Il s'agit alors d'un vitrage dit « monolithique ». Dans le cas où ils sont bombés, notamment en vue de constituer des vitrages pour véhicules, l'empilement de couches minces se trouve de préférence sur une face au moins partiellement non plane.

Le vitrage peut aussi être un vitrage multiple, notamment un double-vitrage, au moins le substrat porteur de l'empilement pouvant être bombé et/ou trempé. Il est préférable dans une configuration de vitrage multiple que l'empilement soit disposé de manière à être tourné du côté de la lame de gaz intercalaire. Dans une structure feuilletée, le substrat porteur de l'empilement est de préférence en contact avec la feuille de polymère.

Lorsque le vitrage est monolithique ou multiple du type double-vitrage ou vitrage feuilleté, au moins le substrat porteur de l'empilement peut être en verre bombé ou trempé, ce substrat pouvant être bombé ou trempé avant ou après le dépôt de l'empilement.

Dans une variante le vitrage est pourvu de moyens permettant d'alimenter ledit empilement en énergie électrique.

L'invention concerne également le procédé de fabrication des substrats selon l'invention, qui consiste à déposer l'empilement de couches minces sur son substrat par une technique sous vide du type pulvérisation cathodique éventuellement assistée par champ magnétique, puis à effectuer sur le substrat revêtu un traitement thermique de bombage/trempe ou recuit sans dégradation de sa qualité optique et/ou mécanique.

Il n'est toutefois pas exclu que la première ou les premières couches de l'empilement puisse(nt) être déposée(s) par une autre technique, par exemple par une technique de décomposition thermique de type pyrolyse.

Les détails et caractéristiques avantageuses de l'invention ressortent des exemples non limitatifs suivants, illustrés à l'aide des figures ci-jointes :
- La figure 1 illustre l'évolution, avant traitement thermique, de la résistance par carré d'un empilement monocouche fonctionnelle pourvu d'un revêtement monocouche de sur-blocage, sans et avec une couche de lissage, en fonction de l'épaisseur de la couche diélectrique placée dessous ;
- La figure 2 illustre l'évolution, après traitement thermique, de la résistance par carré du même empilement monocouche fonctionnelle qu'en figure 1, sans et avec une couche de lissage, en fonction de l'épaisseur de la couche diélectrique placée dessous ;
- La figure 3 illustre l'évolution, avant traitement thermique, de la résistance par carré d'un empilement monocouche fonctionnelle pourvu d'un revêtement monocouche de sur-blocage en fonction de l'épaisseur de la couche de lissage ;
- La figure 4 illustre l'évolution, après traitement thermique, de la résistance par carré du même empilement monocouche fonctionnelle qu'en figure 3 en fonction de l'épaisseur de la couche de lissage ;
- La figure 5 illustre un empilement bicouches fonctionnelles selon l'invention, chaque couche fonctionnelle étant pourvue d'un revêtement de sur-blocage mais pas d'un revêtement de sous-blocage ;
- La figure 6 illustre un empilement bicouches fonctionnelles selon l'invention, chaque couche fonctionnelle étant pourvue d'un revêtement de sous-blocage mais pas d'un revêtement de sur-blocage ;
- La figure 7 illustre un empilement bicouches fonctionnelles selon l'invention, chaque couche fonctionnelle étant pourvue d'un revêtement de sous-blocage et d'un revêtement de sur-blocage ;
- La figure 8 illustre un empilement tricouches fonctionnelles selon l'invention, chaque couche fonctionnelle étant pourvue d'un revêtement de sous-blocage mais pas d'un revêtement de sur-blocage ; et
- La figure 9 illustre un empilement quadricouches fonctionnelles selon l'invention, chaque couche fonctionnelle étant pourvue d'un revêtement de sous-blocage mais pas d'un revêtement de sur-blocage.

Dans les figures illustrant des empilements de couches, les proportions entre les épaisseurs des différents matériaux ne sont pas rigoureusement respectées afin de faciliter leur lecture.

Par ailleurs, dans tous les exemples ci-après l'empilement de couches minces est déposé sur un substrat 10 en verre sodo-calcique d'une épaisseur de 2 mm, sauf mention explicite différente.

Dans tous les cas où un traitement thermique a été appliqué au substrat, il s'agissait d'un recuit pendant environ 5 minutes à une température d'environ 660 °C suivi d'un refroidissement à l'air ambiant (environ 20 °C).

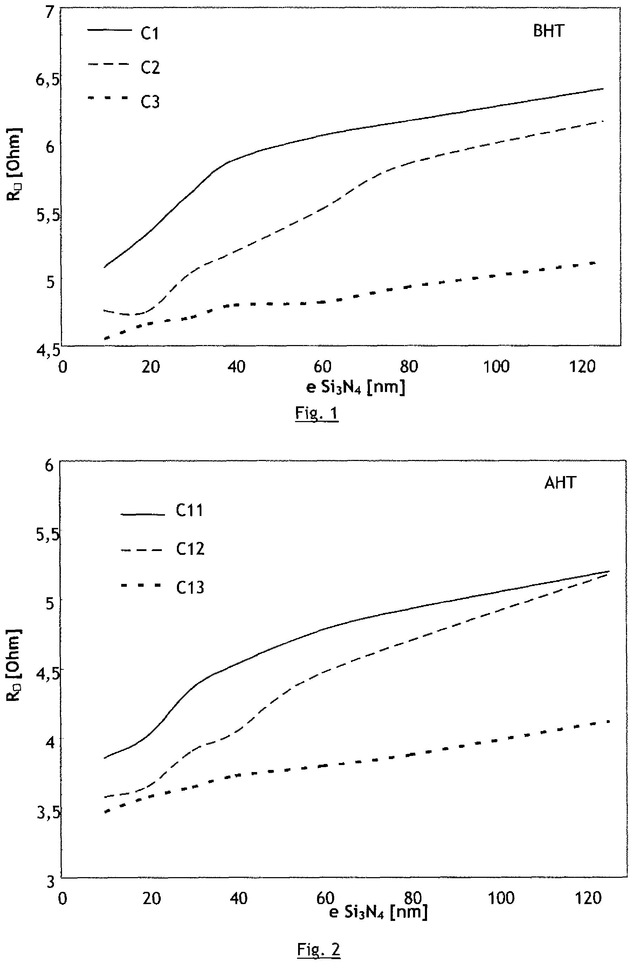

Les figures 1 à 4 ont pour but d'illustrer l'importance de la présence d'une couche de lissage dans un empilement.

Toutefois, l'empilement qui a servi à la réalisation de ces figures n'est pas un empilement selon l'invention car il s'agit d'un empilement monocouche fonctionnelle du type :
Substrat / Si₃N₄ / SnZnOₓ:Sb / ZnO / Ag /Ti / ZnO / Si₃N₄ Variable / Variable / 8nm / 10nm / 2nm / 8nm / 20 nm

Sur les figures 1 et 2, les courbes C1 et C11 illustrent la variation de la résistance par carré (en ohms) de l'empilement en fonction de l'épaisseur de la couche de diélectrique à base de nitrure de silicium (e Si₃N₄) en contact avec le substrat, respectivement avant (BHT) et après (AHT) traitement thermique, lorsque l'empilement n'est pas pourvu d'une couche de lissage.

Les courbes C2 et C12 illustrent la variation de la résistance par carré (en ohms) de l'empilement en fonction de l'épaisseur de la couche de diélectrique à base de nitrure de silicium (e Si₃N₄) en contact avec le substrat, respectivement avant et après traitement thermique, lorsque l'empilement est pourvu d'une couche de lissage en SnZnOₓ:Sb d'une épaisseur de 6 nm (x désigne un nombre non nul).

Les courbes C3 et C13 illustrent la variation de la résistance par carré (en ohms) de l'empilement en fonction de l'épaisseur de la couche de diélectrique à base de nitrure de silicium (e Si₃N₄) en contact avec le substrat, respectivement avant et après traitement thermique, lorsque l'empilement est pourvu d'une couche de lissage à base de SnZnOₓ:Sb d'une épaisseur de 20 nm.

Comme visible sur ces figures 1 et 2, pour une même épaisseur de diélectrique en contact avec le substrat (par exemple 20 nm), la résistance par carré de l'empilement est toujours plus faible - donc meilleure - pour les courbes C2, C3, C12 et C13 lorsque l'empilement comporte une couche de lissage à base de SnZnOₓ:Sb entre la couche de diélectrique à base de nitrure de silicium en contact avec le substrat et la couche de mouillage à base d'oxyde de zinc ZnO sous-jacente à la couche fonctionnelle à base d'argent Ag ; par ailleurs, la résistance par carré de l'empilement est toujours plus faible pour une épaisseur de couche de lissage de 20 nm (courbes C3 et C13).

Il a été vérifié que la couche de lissage en oxyde mixte est amorphe sur toute son épaisseur, alors que la couche de mouillage et la couche fonctionnelle métallique sont toutes les deux cristallisées, sur toute leur épaisseur.

En conséquence, la présence d'une couche de lissage améliore d'une manière importante la résistance par carré de l'empilement à épaisseur de diélectrique sous-jacent comparable et cette amélioration est d'autant plus forte que l'épaisseur de la couche de lissage est importante.

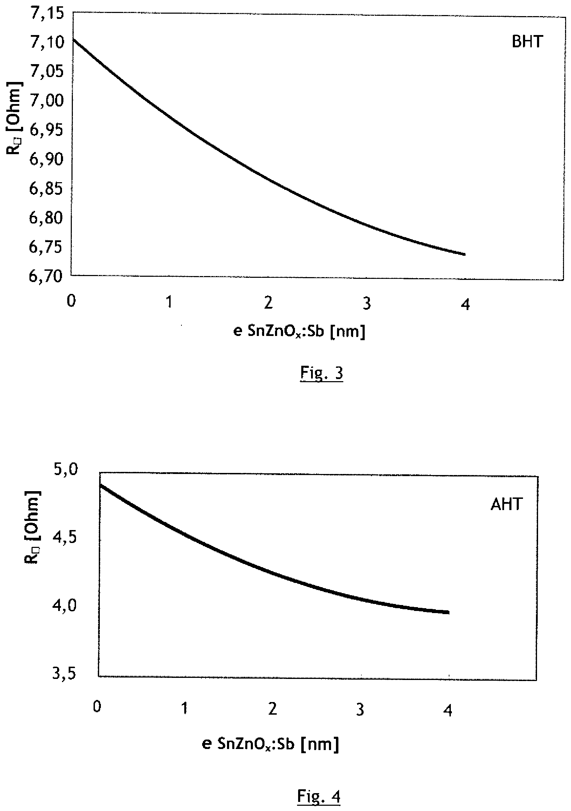

Sur les figures 3 et 4, les courbes illustrent la variation de la résistance par carré (en ohms) de l'empilement en fonction de l'épaisseur de la couche de lissage à base d'oxyde de zinc et d'étain dopé à l'antimoine (e SnZnOₓ:Sb), respectivement avant (BHT) et après (AHT) traitement thermique, lorsque l'empilement est pourvu d'une couche à base de nitrure de silicium Si₃N₄ de 20 nm entre le substrat et la couche à base de SnZnOₓ:Sb.

Il a également été vérifié que la couche de lissage en oxyde mixte est amorphe sur toute son épaisseur, alors que la couche de mouillage et la couche fonctionnelle métallique sont toutes les deux cristallisées, sur toute leur épaisseur.

Comme visible sur ces figures 3 et 4 également, la présence d'une couche de lissage améliore d'une manière importante la résistance par carré de l'empilement pour une couche de lissage comprise entre > 0 et 4 nm d'épaisseur et cette amélioration est d'autant plus forte que l'épaisseur de la couche de lissage est importante.

Des constatations similaires peuvent être faites avec un empilement monocouche fonctionnelle pourvu d'un revêtement de sous-blocage et sans revêtement de sur-blocage ou pourvu d'un revêtement de sous-blocage et d'un revêtement de sur-blocage.

Des essais ont en outre été conduis pour permettre de mesurer la rugosité des couches.

Le tableau 1 ci-après illustre les rugosités mesurées par réflectométrie X et exprimées en nm (la rugosité du substrat étant d'environ 0,4) :

**Tableau 1**

| Couche(s) | Epaisseur (nm) | Rugosité σ (nm) |
|---|---|---|
| Si₃N₄ | 28,5 | 1,1 |
| Verre | Substrat | |
| SnO₂ | 29,5 | 0,8 |
| Verre | Substrat | |
| SnZnOₓ:Sb | 32,0 | 0,7 |
| Verre | Substrat | |
| SnZnOₓ:Sb | 11,2 | 0,8 |
| Si₃N₄ | 19,7 | 0,5 |
| Verre | Substrat | |
| SnO₂ | 10,4 | 0,8 |
| Si₃N₄ | 19,3 | 0,5 |
| Verre | Substrat | |

Comme visible dans ce tableau, la rugosité de la couche à base de nitrure de silicium Si₃N₄ déposée seule sur le verre est élevée, mais la rugosité finale d'un empilement comprenant une couche d'oxyde mixte à base de oxyde d'étain et d'indium SnInOₓ (ITO) ou une couche à base d'oxyde mixte de zinc et d'étain SnZnOₓ:Sb déposée sur la couche à base de nitrure de silicium est moins élevée. La couche de mouillage à base d'oxyde mixte permet ainsi d'améliorer la rugosité de l'interface avec la couche de mouillage, en diminuant cette rugosité.

Partant de ces constatations, il est ainsi possible de déposer sur un substrat 10 un empilement de couches minces comportant une alternance de « n » couches fonctionnelles 40, 80, 120, 160 à propriétés de réflexion dans l'infrarouge et/ou dans le rayonnement solaire, notamment de couches fonctionnelles métalliques à base d'argent ou d'alliage métallique contenant de l'argent, et de « (n + 1) » revêtements 20, 60, 100, 140, 180, avec n nombre entier supérieur ou égal à 2, lesdits revêtements étant composés d'une pluralité de couches diélectriques 24, 26 ; 62, 64, 66 ; 102, 104, 106, 142, 144, 146, 182, 184, de manière à ce que chaque couche fonctionnelle 40, 80, 120, 140 soit disposée entre deux revêtements 20, 60, 100, 140, 180, au moins deux couches fonctionnelles, et de préférence chaque couche fonctionnelle, étant déposée sur une couche de mouillage 30, 70, 110, 150 déposée elle-même respectivement directement sur un revêtement sous-jacent 20, 60, 100, 140.

Ainsi, sur la base des tests monocouche fonctionnelle ci-dessus, plusieurs essais bicouches fonctionnelles ont été réalisés mais tous ne donnent pas satisfaction.

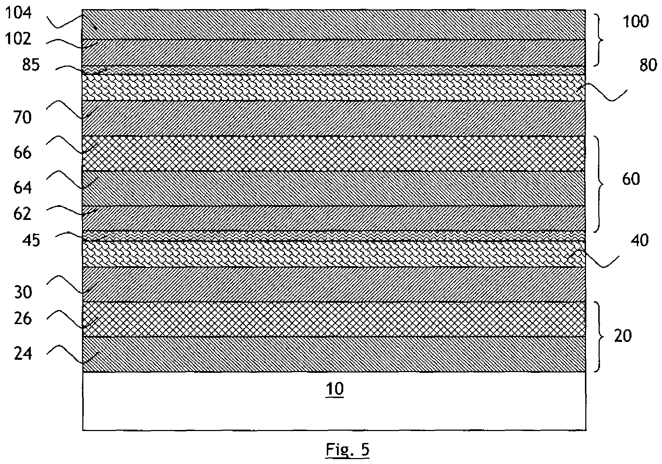

Deux exemples, numérotés 1 et 2, ont été réalisés sur la base de la structure d'empilement bicouches fonctionnelles illustrée figure 5 dans laquelle chaque couche fonctionnelle 40, 80 est pourvue d'un revêtement de sur-blocage 45, 85, mais de revêtement de sous-blocage.

Le tableau 2 ci-après illustre les épaisseurs en nanomètres de chacune des couches :

**Tableau 2**

| Couche | Matériau | Ex. 1 | Ex. 2 |
|---|---|---|---|
| 104 | Si₃N₄ | 20 | 20 |
| 102 | ZnO | 8 | 8 |
| 85 | Ti | 2 | 2 |
| 80 | Ag₂ | 10 | 10 |
| 70 | ZnO | 8 | 8 |
| 66 | SnZnOₓ:Sb | 20 | 6 |
| 64 | Si₃N₄ | 40 | 52 |
| 62 | ZnO | 8 | 8 |
| 45 | Ti | 2 | 2 |
| 40 | Ag₁ | 10 | 10 |
| 30 | ZnO | 8 | 8 |
| 26 | SnZnOₓ:Sb | 6 | 20 |
| 24 | Si₃N₄ | 20 | 6 |

Ainsi, dans l'exemple 1 selon l'invention, l'épaisseur de la couche de lissage 26 à base d'oxyde de zinc et d'étain dopé à l'antimoine SnZnOₓ:Sb du revêtement sous-jacent moins épais 20 est inférieure à l'épaisseur de la couche de lissage 66 à base d'oxyde de zinc et d'étain dopé à l'antimoine SnZnOₓ:Sb du revêtement sous-jacent plus épais 60, alors que dans le contre-exemple 2, l'épaisseur de la couche de lissage 26 du revêtement 20 sous-jacent moins épais est supérieure à l'épaisseur de la couche de lissage 66 du revêtement sous-jacent plus épais 60.

Les résistivités obtenues sont présentées dans le tableau 3 ci-après :

**Tableau 3**

| | | Ex. 1 | Ex. 2 |
|---|---|---|---|
| Avant traitement thermique | R-Ag₂ | 4,80 | 5,4 |
| | R-Ag₁ | 4,75 | 4,5 |
| | R-Total | 2,39 | 2,45 |
| Après traitement thermique | R-Ag₂ | 3,73 | 4,35 |
| | R-Ag₁ | 3,65 | 3,45 |
| | R-Total | 1,84 | 1,92 |

Ainsi, la résistivité de l'exemple 1 selon l'invention est meilleure que celle de l'exemple 2 tant avant traitement thermique qu'après traitement thermique.

Dans le cas de l'exemple 2, l'intégration de la couche de lissage dans un empilement à plusieurs couches fonctionnelles ne permet pas de parvenir à l'amélioration souhaitée et obtenue dans de le cas de l'exemple 1 de la cristallisation des couches fonctionnelles, alors même que (et cela a été vérifié) la couche de lissage est amorphe et la couche de mouillage est cristallisée.

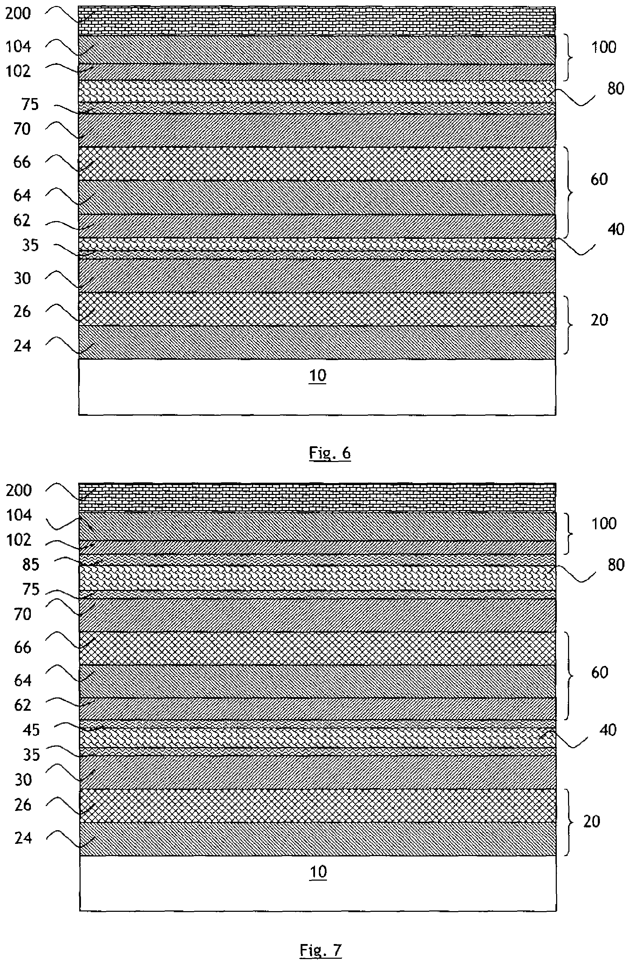

Une autre série d'exemples, numérotée 3, a été réalisée sur la base de la structure d'empilement bicouches fonctionnelles illustrée figure 6, dans laquelle chaque couche fonctionnelle 40, 80 est pourvue d'un revêtement de sous-blocage 35, 75, sans toutefois de couche de protection mécanique 200 visible sur la figure 6.

Le tableau 4 ci-après illustre les épaisseurs en nanomètres de chacune des couches :

**Tableau 4**

| Couche | Matériau | Ex. 3 |
|---|---|---|
| 104 | Si₃N₄ | 27 |
| 102 | ZnO | 8 |
| 80 | Ag₂ | 10 |
| 75 | Ti | 2 |
| 70 | ZnO | 10 |
| 66 | SnZnOₓ:Sb | Y |
| 64 | Si₃N₄ | 65-Y |
| 62 | ZnO | 8 |
| 40 | Ag₁ | 10 |
| 35 | Ti | 2 |
| 30 | ZnO | 7 |
| 26 | SnZnOₓ:Sb | X |
| 24 | Si₃N₄ | 23-X |

Sur cette base six exemples, numérotés 3a à 3f, ont été réalisés.

Le tableau 5 ci-après illustre les valeurs de X et de Y en nanomètres de chaque exemple :

**Tableau 5**

| Ex. | type | X | Y |
|---|---|---|---|
| 3a | X<Y | 2 | 6 |
| 3b | X>Y | 6 | 2 |
| 3c | X<Y | 2 | 10 |
| 3d | X>Y | 10 | 2 |
| 3e | X<Y | 2 | 4 |
| 3f | X>Y | 4 | 2 |

Ainsi, dans les exemples 3a, 3c et 3e selon l'invention, l'épaisseur de la couche de lissage 26 du revêtement sous-jacent moins épais 20 est inférieure à l'épaisseur de la couche de lissage 66 du revêtement sous-jacent plus épais 60, alors que dans les contre-exemples 3b, 3d et 3f, l'épaisseur de la couche de lissage 26 du revêtement 20 sous-jacent moins épais est supérieure à l'épaisseur de la couche de lissage 66 du revêtement sous-jacent plus épais 60.

Les caractéristiques de résistivité, optiques et énergétiques de ces exemples sont reportées dans le tableau 6 ci-après (les caractéristiques optiques et énergétiques ont été mesurées après recuit et insertion dans un vitrage feuilleté présentant la structure : extérieur / Substrat en verre de 2,1 mm / 0,25 mm de PVB / Substrat en verre de 2,1 mm porteur de l'empilement ; l'empilement de couche se trouve ainsi en face 3, numérotée par rapport au sens de la lumière solaire incidente) :

**Tableau 6**

| Ex. | R-(ohms) | T_{E} | T_{L}(A) | a*(D65) | b*(D65) | R_{E} | R_{L} (D65) |
|---|---|---|---|---|---|---|---|
| 3a | 2,7 | 45,02 | 77,25 | -2,36 | -5,75 | 33,40 | 11,29 |
| 3b | 2,9 | 44,58 | 75,30 | -4,88 | -4,64 | 32,70 | 13,08 |
| 3c | 2,6 | 45,46 | 78,31 | -1,98 | -4,78 | 33,36 | 10,96 |
| 3d | 2,8 | 45,21 | 77,33 | -2,81 | -4,38 | 33,08 | 11,79 |
| 3e | 2,8 | 44,96 | 77,49 | -3,02 | -4,51 | 33,43 | 11,42 |
| 3f | 2,9 | 45,12 | 77,81 | -1,79 | -4,72 | 33,64 | 11,19 |

Ainsi, la résistivité de l'empilement (mesurée ici après traitement thermique) des exemples 3a, 3c, 3e selon l'invention est toujours inférieure respectivement aux contre-exemples 3b, 3d, 3f correspondants.

De plus, la transmission énergétique T_{E}, la transmission lumineuse T_{L} mesurée selon l'illuminant A, la réflexion énergétique R_{E}, la réflexion lumineuse R_{L} (D65) mesurée selon l'illuminant D65 et les couleurs en réflexion a* et b* dans le système LAB mesurées selon l'illuminant D65 côté couches ne varient pas de manière vraiment significative entre les exemples selon l'invention et les contre-exemples 3b, 3d, 3f correspondants.

En comparant les caractéristiques optiques et énergétiques mesurées ici avant traitement thermique avec ces mêmes caractéristiques après traitement thermique, aucune dégradation n'a été constatée.

D'autres essais ont été réalisés sur la base de la structure d'empilement bicouches fonctionnelles illustrée figure 7 dans laquelle chaque couche fonctionnelle 40, 80 est pourvue d'un revêtement de sous-blocage 35, 75 et d'un revêtement de sur-blocage 45, 85.

Ces essais ont permis d'arriver à des constatations similaires.

Pour les structures bicouches fonctionnelles, il a été constaté qu'il était préférable que la couche de lissage du revêtement sous-jacent moins épais soit la plus proche du substrat et que par conséquent la couche de lissage du revêtement sous-jacent plus épais soit la plus éloignée du substrat.

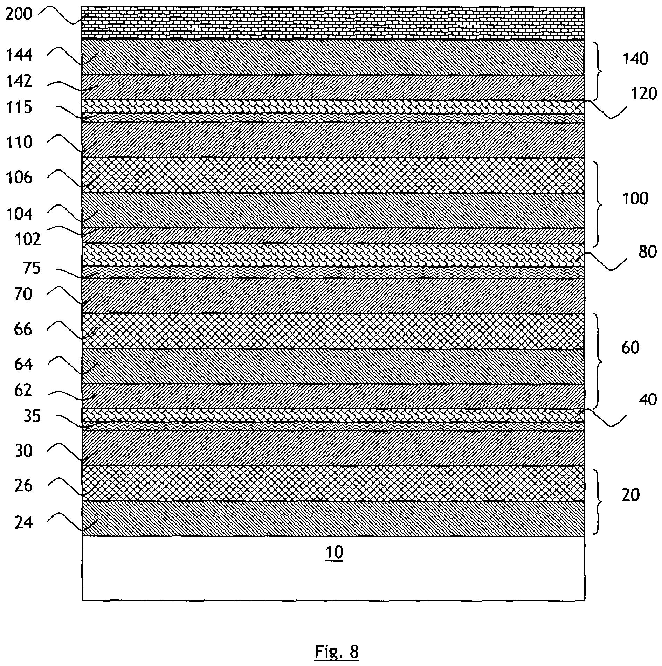

Il est par ailleurs possible d'appliquer l'invention à un empilement à trois couches fonctionnelles, comme par exemple l'empilement illustré en figure 8.

Dans la configuration illustrée, chaque couche fonctionnelle 40, 80, 120 est pourvue d'un revêtement de sous-blocage 35, 75, 115 ; toutefois, il est aussi possible de prévoir en plus ou sans ce revêtement de sous-blocage 35, 75, 115, un revêtement de sur-blocage.

De plus, dans la configuration illustrée, chaque revêtement sous-jacent 20, 60, 100 comporte une couche de lissage 26, 66, 106 conformément à l'invention.

Pour les structures tri couches fonctionnelles, il a été constaté qu'il était préférable que la couche de lissage du revêtement sous-jacent moins épais soit la plus proche du substrat et que la couche de lissage du revêtement sous-jacent plus épais soit la couche de lissage centrale 66 et que la couche la plus éloignée du substrat 106, soit plus épaisse que la couche de lissage 26 la plus proche du substrat et moins épaisse que la couche de lissage centrale 66.

Dans cette structure, il est possible de ne prévoir que deux couches de lissage, c'est-à-dire de prévoir que deux revêtements sous-jacents seulement correspondent à l'invention. Dans ce cas, le revêtement le moins épais desdits deux revêtements sous-jacents est le plus éloigné du substrat.

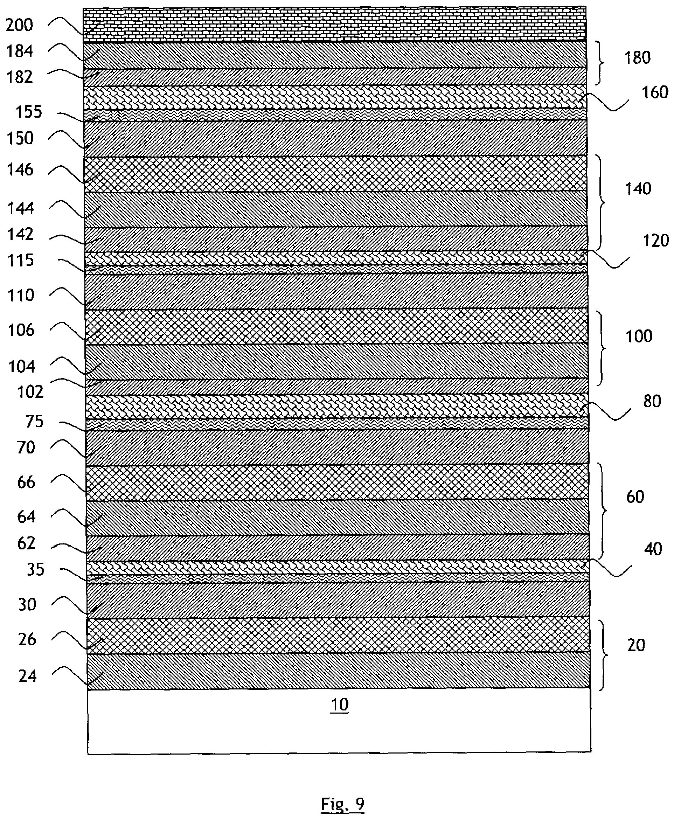

Il est par ailleurs possible d'appliquer l'invention à un empilement à quatre couches fonctionnelles, comme par exemple l'empilement illustré en figure 9.

Dans la configuration illustrée, chaque couche fonctionnelle 40, 80, 120, 160 est pourvue d'un revêtement de sous-blocage 35, 75, 115, 155 ; toutefois, il est aussi de possible de prévoir en plus ou sans ce revêtement de sous-blocage 35, 75, 115, 155, un revêtement de sur-blocage.

De plus, dans la configuration illustrée, chaque revêtement sous-jacent 20, 60, 100, 140 comporte une couche de lissage 26, 66, 106, 146 conformément à l'invention.

Cet empilement peut être obtenu, par exemple, en passant deux fois le substrat 10 dans un dispositif de dépôt d'un empilement bicouches fonctionnelles, comme cela est connu de la demande internationale de brevet N° WO2005/051858, pour déposer :
- lors d'un premier passage les couches 24 à 102, puis
- lors d'un second passage les couches 104 à 182, puis
- dans un appareil de finition du dépôt, les couches 184 et 200.

Dans cette structure, il est possible de ne prévoir que deux couches de lissage, c'est-à-dire de prévoir que deux revêtements sous-jacents seulement correspondent à l'invention. Dans ce cas, le revêtement le moins épais desdits deux revêtements sous-jacents est le plus éloigné du substrat.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (10) verrier transparent muni d'un empilement de couches minces, déposé sur le substrat, comportant une alternance de « n » couches fonctionnelles (40, 80) à propriétés de réflexion dans l'infrarouge et/ou dans le rayonnement solaire, notamment de couches fonctionnelles métalliques à base d'argent ou d'alliage métallique contenant de l'argent, et de « (n + 1) » revêtements (20, 60, 100), avec n nombre entier ≥ 2, lesdits revêtements étant composés d'une pluralité de couches diélectriques (24, 26 ; 64, 66 ; 104), de manière à ce que chaque couche fonctionnelle (40, 80) soit disposée entre deux revêtements (20, 60, 100), au moins deux couches fonctionnelles (40, 80) étant déposées chacune sur une couche de mouillage (30, 70) déposée elle-même respectivement directement sur un revêtement sous-jacent (20, 60), **caractérisé en ce que** une couche de lissage (26, 66) non cristallisée est prévue sous ladite couche de mouillage (30, 70) qui elle est cristallisée pour permettre une croissance adéquate de la couche fonctionnelle (40, 80) située au-dessus de cette couche de mouillage (30, 70), directement au contact de la couche de mouillage ou par l'intermédiaire d'un revêtement de sous-blocage, **en ce que** deux revêtements sous-jacent (20, 60) comprennent chacun au moins une couche diélectrique (24, 64) et au moins une dite couche de lissage (26, 66) non cristallisée en un matériau différent du matériau de ladite couche diélectrique à l'intérieur de chaque revêtement, ladite couche de lissage (26, 66) étant en contact avec ladite couche de mouillage (30, 70) sus-jacente, chaque couche de mouillage (30, 70) sous-jacente à une couche fonctionnelle (40, 80) étant à base d'oxyde de zinc, **en ce que** ces deux revêtements sous-jacent (20, 60) étant d'épaisseur différentes, l'épaisseur de la couche de lissage (26, 66) du revêtement sous-jacent (20, 60) présentant une épaisseur totale inférieure à celle de l'autre revêtement sous-jacent (60, 20) est inférieure ou égale à l'épaisseur de la couche de lissage (66, 26) de cet autre revêtement sous-jacent (60, 20) **et en ce que** toutes les couches de lissage (26, 66) sont complètement amorphe sur toute leur épaisseur et sont une couche d'oxyde mixte à base de zinc et d'étain.

2. Substrat (10) selon la revendication 1, ***caractérisé en ce que*** l'empilement comporte deux couches fonctionnelles alternées avec trois revêtements.

3. Substrat (10) selon la revendication 1, ***caractérisé en ce que*** l'empilement comporte trois couches fonctionnelles alternées avec quatre revêtements.

4. Substrat (10) selon la revendication 1, ***caractérisé en ce que*** l'empilement comporte quatre couches fonctionnelles alternées avec cinq revêtements.

5. Substrat (10) selon l'une quelconque des revendications précédentes, ***caractérisé en ce que*** le revêtement sous-jacent le plus proche du substrat est le revêtement le moins épais desdits deux revêtements sous-jacents (20, 60).

6. Substrat (10) selon l'une quelconque des revendications 3 à 5, ***caractérisé en ce que*** le revêtement sous-jacent le plus éloigné du substrat est le revêtement le moins épais de deux revêtements sous-jacents adjacents.

7. Substrat (10) selon l'une quelconque des revendications précédentes, ***caractérisé en ce qu'***au moins une couche de lissage (26, 66), voire toutes les couches de lissage (26, 66), est (ou sont) une couche d'oxyde non stoechiométrique en oxygène.

8. Substrat (10) selon l'une quelconque des revendications précédentes, ***caractérisé en ce que*** la ou chaque couche de lissage (26, 66) présente une épaisseur géométrique entre 0,1 et 30 nm et de préférence comprise entre 0,2 et 10 nm.

9. Substrat (10) selon l'une quelconque des revendications précédentes, ***caractérisé en ce qu'***au moins une, et de préférence chaque, couche fonctionnelle (40, 80) est disposée directement sur au moins un revêtement de blocage (35, 75) sous-jacent et/ou directement sous au moins un revêtement de blocage (45, 85) sus-jacent.

10. Substrat (10) selon la revendication précédente, ***caractérisé en ce qu'***au moins un revêtement de blocage (35, 45, 75, 85) est à base de Ni ou de Ti ou est à base d'un alliage à base de Ni, notamment est à base d'un alliage de NiCr.

11. Substrat (10) selon l'une quelconque des revendications précédentes, ***caractérisé en ce qu'***au moins une, et de préférence chaque, couche diélectrique (24, 64) adjacente à une couche de lissage (26, 66) à l'intérieur desdits revêtements sous-jacents (20, 60) est à base de nitrure, notamment de nitrure de silicium et/ou de nitrure d'aluminium.

12. Vitrage incorporant au moins un substrat (10) selon l'une quelconque des revendications précédentes, éventuellement associé à au moins un autre substrat.

13. Vitrage selon la revendication précédente monté en monolithique ou en vitrage multiple du type double-vitrage ou vitrage feuilleté, ***caractérisé en ce qu'au*** moins le substrat porteur de l'empilement est bombé ou trempé.

14. Vitrage selon la revendication 12 ou 13, ***caractérisé en ce qu'***il est pourvu de moyens permettant d'alimenter ledit empilement en énergie électrique.

15. Procédé de fabrication du substrat (10) selon l'une quelconque des revendications 1 à 11, ***caractérisé en ce qu'on*** dépose l'empilement de couches minces sur le substrat par une technique sous vide du type pulvérisation cathodique éventuellement assistée par champ magnétique, puis ***en ce qu'on*** effectue un traitement thermique du type bombage, trempe ou recuit sur ledit substrat, sans dégradation de sa qualité optique et/ou mécanique.

## Patentansprüche

1. Durchsichtiges Substrat (10) aus Glas, das mit einer Stapelung von Dünnschichten versehen ist, die auf dem Substrat abgelagert ist, die eine Abwechslung aus "n" Funktionsschichten (40, 80) mit Reflexionseigenschaften im Infrarotbereich und/oder im Sonnenstrahlungsbereich umfasst, insbesondere metallische Funktionsschichten auf der Basis von Silber oder einer metallischen Legierung, die Silber enthält, und von "(n+1)" Beschichtungen (20, 60, 100), wobei n eine Ganzzahl ≥ 2 ist, wobei die Beschichtungen aus einer Vielzahl dielektrischer Schichten (24, 26; 64, 66; 104) derart bestehen, dass jede Funktionsschicht (40, 80) zwischen zwei Beschichtungen (20, 60, 100) angeordnet ist, wobei mindestens zwei Funktionsschichten (40, 80) jeweils auf einer Benetzungsschicht (30, 70) abgelagert sind, die selbst jeweils direkt auf einer darunterliegenden Beschichtung (20, 60) abgelagert ist, **dadurch gekennzeichnet, dass** eine nicht kristallisierte Glättungsschicht (26, 66) unter der Benetzungsschicht (30, 70) vorgesehen ist, die kristallisiert ist, um ein zweckdienliches Aufwachsen der Funktionsschicht (40, 80), die über dieser Benetzungsschicht (30, 70) direkt in Berührung mit der Benetzungsschicht oder anhand einer Unterblockierungsbeschichtung liegt, zu erlauben, **dass** zwei darunterliegende Beschichtungen (20, 60) jeweils mindestens eine dielektrische Schicht (24, 64) und mindestens eine nicht kristallisierte Glättungsschicht (26, 66) aus einem Material, das von dem Material der dielektrischen Schicht unterschiedlich ist, im Inneren jeder Beschichtung umfassen, wobei die Glättungsschicht (26, 66) mit der darunterliegenden Benetzungsschicht (30, 70) in Berührung ist, wobei jede darunterliegende Benetzungsschicht (30, 70) mit einer Funktionsschicht (40, 80) auf der Basis von Zinkoxid beruht, **dass** diese zwei darunterliegenden Beschichtungen (20, 60) unterschiedliche Stärke haben, wobei die Stärke der Glättungsschicht (26, 66) der darunterliegenden Beschichtung (20, 60) eine Gesamtstärke aufweist, die kleiner ist als die der anderen darunterliegenden Beschichtung (60, 20), kleiner oder gleich der Stärke der Glättungsschicht (66, 26) dieser anderen darunterliegenden Beschichtung (60, 20) ist, und **dass** alle Glättungsschichten (26, 66) auf ihrer gesamten Stärke völlig amorph sind und eine Mischoxidschicht auf der Basis von Zink und Zinn sind.

2. Substrat (10) nach Anspruch 1, ***dadurch gekennzeichnet, dass*** die Stapelung zwei Funktionsschichten umfasst, die mit drei Beschichtungen abwechseln.

3. Substrat (10) nach Anspruch 1, ***dadurch gekennzeichnet, dass*** die Stapelung drei Funktionsschichten umfasst, die mit vier Beschichtungen abwechseln.

4. Substrat (10) nach Anspruch 1, ***dadurch gekennzeichnet, dass*** die Stapelung vier Funktionsschichten umfasst, die mit fünf Beschichtungen abwechseln.

5. Substrat (10) nach einem beliebigen der vorhergehenden Ansprüche, ***dadurch gekennzeichnet, dass*** die darunterliegende Beschichtung, die dem Substrat am nächsten liegt, die dünnere der zwei darunterliegenden Beschichtungen (20, 60) ist.

6. Substrat (10) nach einem beliebigen der Ansprüche 3 bis 5, ***dadurch gekennzeichnet, dass*** die darunterliegende Beschichtung, die am weitesten von dem Substrat entfernt ist, die dünnere der zwei benachbarten darunterliegenden Beschichtungen ist.

7. Substrat (10) nach einem beliebigen der vorhergehenden Ansprüche, ***dadurch gekennzeichnet, dass*** mindestens eine Glättungsschicht (26, 66), ja sogar alle Glättungsschichten (26, 66) aus einer Oxidschicht besteht (oder bestehen), die nicht Sauerstoff-stöchiometrisch ist.

8. Substrat (10) nach einem beliebigen der vorhergehenden Ansprüche, ***dadurch gekennzeichnet, dass*** die oder jede Glättungsschicht (26, 66) eine geometrische Stärke zwischen 0,1 und 30 nm und bevorzugt zwischen 0,2 und 10 nm aufweist.

9. Substrat (10) nach einem beliebigen der vorhergehenden Ansprüche, ***dadurch gekennzeichnet, dass*** mindestens eine und bevorzugt jede Funktionsschicht (40, 80) direkt auf mindestens einer darunterliegenden Blockierungsbeschichtung (35, 75) und/oder direkt unter mindestens einer darunterliegenden Blockierungsbeschichtung (45, 85) angeordnet ist.

10. Substrat (10) nach dem vorhergehenden Anspruch, ***dadurch gekennzeichnet, dass*** mindestens eine Blockierungsbeschichtung (35, 45, 75, 85) auf Ni oder Ti basiert oder auf einer Legierung auf Ni-Basis, insbesondere auf einer NiCr-Legierung, basiert.

11. Substrat (10) nach einem beliebigen der vorhergehenden Ansprüche, ***dadurch gekennzeichnet, dass*** mindestens eine und bevorzugt jede dielektrische Schicht (24, 64), die mit einer Glättungsschicht (26, 66) im Inneren der darunterliegenden Beschichtungen (20, 60) benachbart ist, auf Nitrid basiert, insbesondere auf Siliziumnitrid und/oder Aluminiumnitrid.

12. Verglasung, die mindestens ein Substrat (10) nach einem beliebigen der vorhergehenden Ansprüche gegebenenfalls in Verbindung mit mindestens einem anderen Substrat enthält.

13. Verglasung nach dem vorhergehenden Anspruch, die monolithisch oder als Mehrfachverglasung vom Typ Doppelverglasung oder Verbundverglasung aufgebaut ist, ***dadurch gekennzeichnet, dass*** mindestens das Trägersubstrat der Stapelung gewölbt oder gehärtet ist.

14. Verglasung nach Anspruch 12 oder 13, ***dadurch gekennzeichnet, dass*** sie mit Mitteln versehen ist, die es erlauben, die Stapelung mit elektrischer Energie zu versorgen.

15. Verfahren zur Herstellung des Substrats (10) nach einem beliebigen der Ansprüche 1 bis 11, ***dadurch gekennzeichnet, dass*** die Stapelung aus Dünnschichten auf dem Substrat anhand einer Vakuumtechnik vom Typ Sputtern, eventuell unterstützt durch ein Magnetfeld, ablagert wird, dass dann eine Wärmebehandlung vom Typ Wölben, Härten oder Glühen auf dem Substrat ohne Beschädigung seiner optischen und/oder mechanischen Qualität ausführt wird.

## Claims

1. A substrate (10), especially a transparent glass substrate, provided with a thin-film multilayer comprising an alternation of n functional layers (40, 80) having reflection properties in the infrared and/or in solar radiation, especially metallic functional layers based on silver or on a metal alloy containing silver, and (n + 1) coatings (20, 60, 100), where n is an integer ≥ 2, said coatings being composed of a plurality of dielectric layers (24, 26; 64, 66; 104), so that each functional layer (40, 80) is placed between two coatings (20, 60, 100), at least two functional layers (40, 80) each being deposited on a wetting layer (30, 70) itself deposited respectively directly onto a subjacent coating (20, 60), **characterized in that** a noncrystalline smoothing layer (26, 66) is provided under said wetting layer (30, 70) which is crystalline in order to allow suitable growth of the functional layer (40, 80) located on top of this wetting layer (30, 70), directly in contact with the wetting layer directly or via an underblocking coating, **in that** two subjacent coatings (20, 60) each comprise at least one dielectric layer (24, 64) and at least one noncrystalline smoothing layer (26, 66) made from a material that is different from the material of said dielectric layer within each coating, said smoothing layer (26, 66) being in contact with said superjacent wetting layer (30, 70), each wetting layer (30, 70) subjacent to a functional layer (40, 80) being based on zinc oxide, **in that** these two subjacent coatings (20, 60) being of different thicknesses, the thickness of the smoothing layer (26, 66) of the subjacent coating (20, 60) that has a total thickness of less than that of the other subjacent coating (60, 20) is less than or equal to the thickness of the smoothing layer (66, 26) of this other subjacent coating (60, 20) **and in that** all the smoothing layer (26, 66) are completely amorphous over their entire thickness and are a mixed oxide based on zinc and tin.

2. The substrate (10) as claimed in claim 1, **characterized in that** the multilayer comprises two functional layers alternating with three coatings.

3. The substrate (10) as claimed in claim 1, **characterized in that** the multilayer comprises three functional layers alternating with four coatings.

4. The substrate (10) as claimed in claim 1, **characterized in that** the multilayer comprises four functional layers alternating with five coatings.

5. The substrate (10) as claimed in any one of the preceding claims, **characterized in that** the subjacent coating closest to the substrate is the thinner coating of said two subjacent coatings (20, 60).

6. The substrate (10) as claimed in any one of claims 3 to 5, **characterized in that** the subjacent coating furthest from the substrate is the thinner coating of two adjacent subjacent coatings.

7. The substrate (10) as claimed in any one of the preceding claims, **characterized in that** at least one smoothing layer (26, 66), even all the smoothing layers (26, 66), is (or are) an oxide layer having a nonstoichiometric amount of oxygen.

8. The substrate (10) as claimed in any one of the preceding claims, **characterized in that** the or each smoothing layer (26, 66) has a geometric thickness between 0.1 and 30 nm and preferably between 0.2 and 10 nm.

9. The substrate (10) as claimed in any one of the preceding claims, **characterized in that** at least one, and preferably each, functional layer (40, 80) is placed directly onto at least one subjacent blocking coating (35, 75) and/or directly under at least one superjacent blocking layer (45, 85).

10. The substrate (10) as claimed in the preceding claim, **characterized in that** at least one blocking coating (35, 45, 75, 85) is based on Ni or on Ti or is based on an Ni-based alloy, and especially is based on an NiCr alloy.

11. The substrate (10) as claimed in any one of the preceding claims, **characterized in that** at least one, and preferably each, dielectric layer (24, 64) adjacent to a smoothing layer (26, 66) within said subjacent coatings (20, 60) is based on nitride, especially on silicon nitride and/or aluminum nitride.

12. A glazing unit incorporating at least one substrate (10) as claimed in any one of the preceding claims, optionally combined with at least one other substrate.

13. The glazing unit as claimed in the preceding claim, mounted in monolithic form or as multiple glazing of the double-glazing or laminated glazing type, **characterized in that** at least the substrate carrying the multilayer is curved or toughened.

14. The glazing unit as claimed in claim 12 or 13, **characterized in that** it is provided with means that enable said multilayer to be supplied with electric power.

15. A process for manufacturing the substrate (10) as claimed in any one of claims 1 to 11, **characterized in that** the thin-film multilayer is deposited on the substrate by a vacuum technique of the sputtering, optionally magnetron sputtering, type and then **in that** a heat treatment of the bending, toughening or annealing type is carried out on said substrate without degrading its optical and/or mechanical quality.
